(19) Europäisches Patentamt
European Patent Office
Office européen des brevets

(11) Veröffentlichungsnummer: **0 109 966**
**B1**

(12) **EUROPÄISCHE PATENTSCHRIFT**

(45) Veröffentlichungstag der Patentschrift: **11.02.87**

(51) Int. Cl.⁴: **H 03 D 3/00,** H 04 N 9/66

(21) Anmeldenummer: **82110945.1**

(22) Anmeldetag: **26.11.82**

(54) Schaltungsanordnung zur digitalen FM-Demodulation.

(43) Veröffentlichungstag der Anmeldung:
**13.06.84 Patentblatt 84/24**

(45) Bekanntmachung des Hinweises auf die
Patenterteilung:
**11.02.87 Patentblatt 87/07**

(84) Benannte Vertragsstaaten:
**DE FR GB IT NL**

(56) Entgegenhaltungen:
**EP-A-0 029 376**
**EP-A-0 046 213**
**EP-A-0 061 377**
**EP-A-0 068 571**
**EP-A-0 068 579**

**ELECTRONIC LETTERS, Band 15, Nr. 16,
August 1979, London F.G.A. COUPE "Digital
frequency discriminator" Seiten 489-490**

(73) Patentinhaber: **Deutsche ITT Industries GmbH
Hans-Bunte-Strasse 19 Postfach 840
D-7800 Freiburg (DE)**
(84) **DE**

(73) Patentinhaber: **ITT INDUSTRIES INC.
320 Park Avenue
New York, NY 10022 (US)**
(84) **FR GB IT NL**

(72) Erfinder: **Smith, Robert
Am See 7
D-7803 Gundelfingen (DE)**

(74) Vertreter: **Morstadt, Volker, Dipl.-Ing.
c/o Deutsche ITT Industries GmbH
Patent/Lizenzabteilung Postfach 840 Hans-
Bunte-Strasse 19
D-7800 Freiburg/Brsg. (DE)**

EP 0 109 966 B1

Beschreibung

Die Erfindung betrifft eine Schaltungsanordnung zur digitalen FM-Demodulation von durch Abstastung mittels eines Abtastsignals aus einem analogen frequenzmodulierten Signal gebildeten, zeitlich äquidistanten Abtastwerten, die dem Eingang einer Kette von zwei hintereinandergeschalteten, um jeweils die Periodendauer des Abtastsignals verzögernden Verzögerungsstufen zugeführt und mit dem ersten Eingang eines Addierers gekoppelt sind, dessen zweiter Eingang mit dem Ausgang der letzten Verzögerungsstufe gekoppelt ist und dessen Ausgang am Dividend-Eingang eines Dividierers liegt, dessen Divisor-Eingang mit dem Ausgang der ersten Verzögerungsstufe gekoppelt ist und dessen Ausgangssignal entweder direkt oder nach Bildung der entsprechenden Arcussinus-Werte als demoduliertes Digitalsignal dient, vgl. den Oberbegriff des Anspruchs 1. Eine derartige Anordnung ist aus der Offenlegungsschrift DE—A—30 30 853 bekannt. Darin ist allgemein angegeben, daß die digitale FM-Demodulation prinzipiell durch entsprechende Verknüpfung dreier Abtastwerte erreicht werden kann, konkret ist jedoch nur zu entnehmen, daß drei aufeinanderfolgende Abtastwerte wie folgt zu verknüpfen sind: der erste und der dritte Abtastwert werden addiert und durch den zweiten dividiert. Schaltungsmäßig führt dies dann zu der eingangs erwähnten Schaltungsanordnung.

Nach dem Abtasttheorem muß bekanntlich die Abtastfrequenz mindestens doppelt so groß sein wie die höchste im abzutastenden Signal vorhandene Frequenz. Zur Darlegung eines wesentlichen Nachteils der bekannten Anordnung wird daher zunächst auf den Sonderfall bezug genommen, daß die Frequenz des Abtastsignals gerade viermal so groß ist wie die Frequenz des abzutastenden Signals und daß die Signalfrequenz in üblicher Weise frequenzmoduliert ist. Dann ist das Vorzeichen eines ersten Abtastwerts entgegengesetzt zu dem des zugehöigen dritten Abtastwerts von drei aufeinanderfolgenden Abtastwerten, und außerdem sind die Beträge des ersten und des dritten Abtastwerts praktisch einander gleich. Dies bedeutet, daß die aus diesen beiden Werten voraussetzungsgemäß zu bildende Summe um den Nullpunkt liegende kleine Zahlenwerte ergibt, was bei ausrichendem Auflösungsvermögen zu entsprechend hoher Stellenzahl der zugehörigen Digitalsignale, also der entsprechenden Digitalwörter, führt. Diese Eigenschaft der bekannten Anordnung fällt insbesondere dann ins Gewicht, wenn der erste und der dritte Abtastwert gerade aus der Umgebung des positiven und des negativen Scheitelswerts des abzutastenden Signals stammen.

Hier will die in den Ansprüchen gekennzeichnete Erfindung Abhilfe schaffen, und es liegt ihr daher die Aufgabe zugrunde, die bekannte Anordnung so abzuwandeln, daß das Auflösungsvermögen bei konstanter vorgegebener Stellenzahl der Abtastwerte unabhängig von der zeitlichen Lage der Abtastwerte bezüglich des abgetasteten Signals ist.

Die Erfindung erreicht dies dadurch daß vier, im einfachsten Fall aufeinanderfolgende, Abtastwerte derart ausgewertet werden, daß diejenige in der Viererfolge von Abtastwerten enthaltene Dreierfolge an den Addierer und den Dividierer gelangt, die das beste Auflösungsvermögen erbringt. Die Anordnung ist dabei so getroffen, daß immer diejenige Dreierfolge ausgewertet wird, deren erster und dritter Abtastwert in der Umgebung der größten Steigung des abzutastenden Signals liegen; bei einem rein sinusförmigen abzutastenden Signals wären dies Werte in der Umgebung des Nulldurchgangs. Der Auswahl der entsprechenden Dreierfolge dienen bei der Erfindung der Komparator und die Bus-Umschalter.

Nach einer Weiterbildung der Erfindung läßt sich das Auflösungsvermögen weiter erhöhen, wenn nicht aufeinanderfolgende Abtastwerte entsprechend dem der Erfindung zugrundeliegenden Prinzip ausgewertet werden, sondern von einer längeren Folge von abtastwerten deren erster, nach einer geraden Anzahl von ausgelassenen Abtastwerten zwei aufeinanderfolgende und nach wiederum derselben geraden Anzahl von ausgelassenen Abtastwerten der letzte Abtastwert der Folge.

Der wesentliche Vorteil der Erfindung ergibt sich unmittelbar durch die Lösung der gestellten Aufgabe, d.h. die Schaltungsanordnung zur digitalen FM-Demodulation kann bei vorgegebenem Auflösungsvermögen mit konstanter Stellenzahl insbesondere des Addierers realisiert werden.

Aus der EP—A—61 377 ist ein anderes Prinzip zur digitalen FM-Demodulation bekannt, das mit der Schaltungsanordnung der Erfindung lediglich gemeinsam hat, daß zwei in Serie liegende Verzögerungsstufen vorgesehen sind, deren jeweilige Verzögerungzeit gleich der Periodendauer des Abtastsignals ist. Diese Signale werden dann allerdings in speziellen Rechenschaltungen weiterverarbeitet.

Die Erfindung wird nun anhand der Figuren der Zeichnung näher erläutert.

Fig. 1 zeigt ein schematisches Prinzipschaltbild eines Ausführungsbeispiels der Erfindung, und

Fig. 2 zeigt ein schematisches Prinzipschaltbild eines Ausführungsbeispiels der bereits erwähnten Weiterbildung der Erfindung.

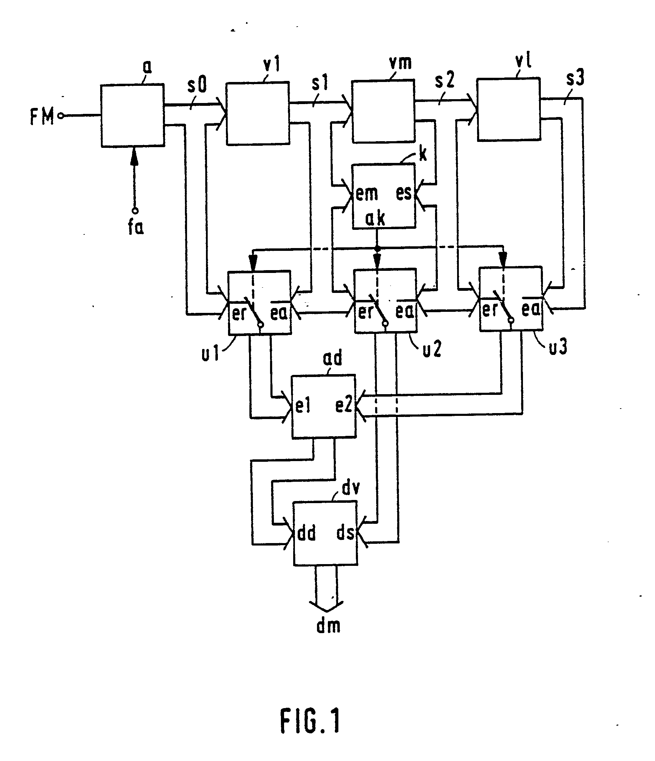

Die Fig. 1 zeigt in Form eines schematischen Blockschaltbilds die Schaltungsanordnung eines Ausführungsbeispiels der Erfindung. Das digital zu demodulierende analoge frequenzmodulierte Signal FM ist der Abtaststufe a eingangsseitig zugeführt, die vom Abtastsignal fa gesteuert ist und an ihrem Ausgang zeitlich äquidistante Abtastwerte in Form von entsprechenden Digitalsignalen bzw. -wörtern abgibt. Durch die bandförmigen Verbindungsleitungen zwischen den einzelnen Teilschaltungen der Fig. 1 ist die bei der Erfindung verwendete parallele Signalverarbeitung angedeutet. Die bandförmigen Verbindungsleitungen kennzeichnen somit eine Anzahl paralleler Leitungen, die üblicherweise auch als Bus bezeichnet wird. Gegenüber den nach dem eingangs erwähnten Stand der Technik lediglich vorgesehenen zwei Verzögerungsstufen, die in Fig. 1 der ersten und der letzten Verzögerungsstufe v1, v1 entsprechen, ist bei der Erfindung mindestens eine weitere, gleichartige, mittlere Verzögerungsstufe vm vorgesehen. Die Kette von Verzögerungsstufen enthält also eine ungerade Anzahl von Stufen, die von den Abtastwerten durchlaufen werden.

Das Eingangssignal der mittleren Verzögerungsstufe vm, liegt am Minuend-Eingang em und deren Ausgang am Subtrahend-Eingang es des Komparators k.

Der jeweilige eingang der ersten, der mittleren bzw. letzten Verzögerungsstufe v1, vm, vl liegt am jeweiligen Ruhekontakteingang er des ersten, zweiten bzw. dritten Bus-Umschalters u1, u2, u3. Der jeweilige Steuereingang der drei Bus-Umschalter ist mit dem Minuend-größer-Subtrahend-Ausgang ak des Komparators k verbunden. Erscheint an diesem Ausgang bei vorausgesetzter positiver Logik der positivere Pegel H zweier Binärpegel H, L, ist also das Signal am Eingang em des Komparators k größer als das am Eingang es, so befinden sich die drei Bus-Umschalter u1, u2, u3 in der gezeichneten Stellung, d.h. das jeweilige Eingangssignal der Verzögerungsstufen v1, vm, vl ist zum Ausgang der Bus-Umschalter durchgeschaltet. Liegt andererseits am Ausgang ak des Komparators k ein L-Pegel, so schalten die Bus-Umschalter auf den jeweiligen Arbeitskontakt um, und es gelangt somit das am zugehörigen Arbeitskontakt-Eingang ea liegende jeweilige Ausgangssignal der drei Verzögerungsstufen v1, vm, vl an den Ausgang der Bus-Umschalter.

Zur zeichnerischen Darstellung der Bus-Umschalter ist das Schaltsymbol für einen mechanischen Umschalter gewählt, zu dessen Signaleingängen bzw. -ausgang die oben erwähnten Busse führen. Es ist somit klar, daß die Bus-Umschalter aus so vielen eizelnen elektronischen Umschaltern bestehen, wie die erwähnten Busse Einzelleitungen haben.

Der Ausgang des ersten Bus-Umschalters u1 und der des dritten Bus-Umschalters u3 liegen am ersten bzw. zweiten Eingang e1, e2 des Addierers ad. Der Ausgang des zweiten Bus-Umschalters u2 liegt am Divisor-Eingang ds des Dividierers dv und der Ausgang des Addierers am Dividend-Eingang des Dividierers dv, dessen Ausgangssignal dm entweder direkt als demoduliertes Digiralsignal dient oder einer Stufe zur Bildung der entsprechenden Arcussinus-Werte zugeführt werden kann, deren Ausgangssignal dann als demoduliertes Digitalsignal dient.

Bei der Anordnung nach Fig. 1 wird also erreicht, daß aus vier aufeinanderfolgenden Abtastwerten derjenige zum mittleren von dreien gemacht wird, der unter zwei benachbarten den größten Wert hat. Dann ist gewährleistet, daß der erste und der letzte Abtastwert der so ausgewählten Dreierfolge im Bereich der größten Steilheit des abzutastenden Signals liegen und das Auflösungsvermögen ist optimiert.

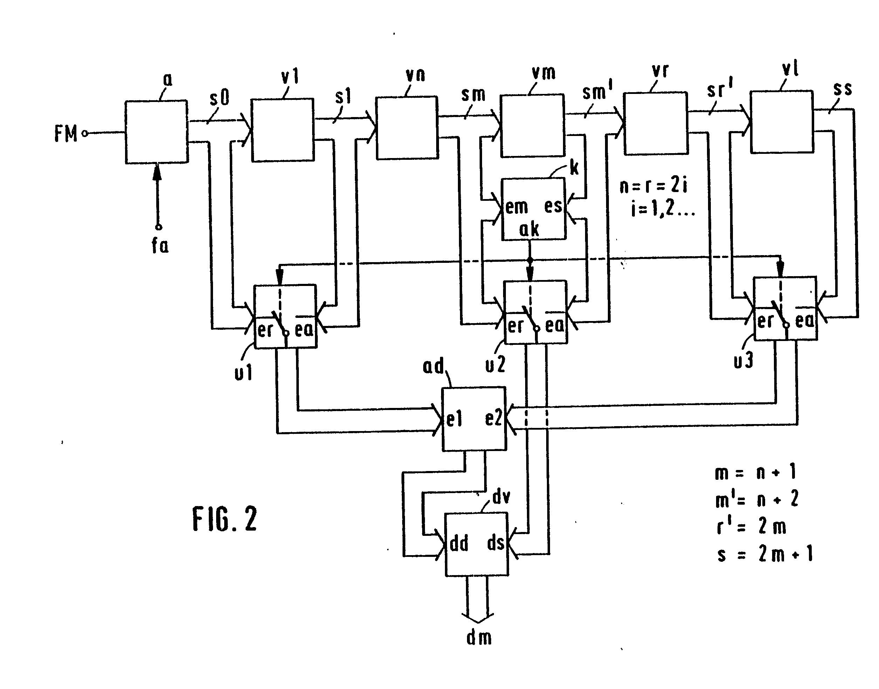

Die Fig. 2 zeigt eine Weiterbildung der Anordnung nach Fig. 1, mit der eine weitere Verbesserung des Auflösungsvermögens erreicht werden kann. Die Weiterbildung besteht im wesentlichen darin, daß, wie oben bereits erwähnt wurde, aus einer längeren folge von Abtastwerten jeweils drei Abtastwerte verarbeitet werden, wobei zwischen dem ersten und dem mittleren sowie dem mittleren und dem letzten Abtastwert eine gerade Anzahl von aufeinanderfolgenden Abtastwerten nicht benutzt wird. Dies führt im Schaltbild der Fig. 2 zur Einfügung von jeweils einer geraden Anzahl n, r zusätzlicher Verzögerungsstufen vn, vr vor und hinter der mittleren Verzögerungsstufe vm. Diese Einfügung erfolgt derart, daß die zusätzlichen Verzögerungsstufen vn zwischen dem Arbeitskontakteingang ea des ersten Bus-Umschalters u1 und dem Ruhekontakteingang er des zweiten Bus-Umschalters u2 und die zusätzlichen Verzögerungsstufen vr zwischen dem Arbeitskontakteingang ea des zweiten Bus-Umschalters u2 und dem Ruhekontakteingang er des dritten Bus-Umschalters u3 angeordnet sind.

Bei der digitalen FM-Demodulation von SECAM-Fernsehsignalen sind bevorzugt jeweils sechs zusätzliche Verzögerungsstufen vn, vr in die Kette von Verzögerungsstufen wie oben angegeben eingefügt.

Werden die Digitalsignale an den Eingängen bzw. Ausgänge der drei Verzögerungsstufen v1, vm, vl, wie in Fig. 1 angegeben, mit s0, s1, s2, s3 bezeichnet, so läßt sich das Ausgangssignal dm des Dividierers dv bei der gezeichneten Stellung der Bus-Umschalter u1, u2, u3 wie folgt angeben:

$$dm = -F(s0 + s2)/\pi \, s1 \text{ bzw.}$$
$$dm = -(2F/\pi)arcsin(s0 + s2)/2s1,$$

wobei mit F die Trägerfrequenz des analogen frequenzmodulierten Signals FM bezeichnet ist.

Für die Anordnung nach Fig. 2 gilt eine entsprechende Formel:

$$dm = (-1)^{(m+1)/2}F(s0 + sr')/\pi \, msm.$$

Für die erwähnte Ausführungsform mit jeweils sechs zusätzlichen Verzögerungsstufen vn, vr gelten somit folgende Zahlenwerte für die einzelnen Indizes:

$$m = 7, \, r' = 14, \, s = 15.$$

In diesem Falle ergibt sich als Ausgangssignal des Dividierers

$$dm = F(s0 + s14)/7\pi \, s7.$$

## Patentansprüche

1. Schaltungsanordnung zur digitalen FM-Demodulation von durch Abtastung mittels eines Abtastsignals (fa) aus einem analogen frequenzmodulierten Signal (FM) gebildeten, zeitlich äquidistanten Abtastwerten (s0), die dem Eingang einer Kette von zwei hintereinandergeschalteten, um jeweils die Periodendauer des Abtastsignals (fa) verzögernden Verzögerungsstufen (v1, vl) zugeführt und mit dem ersten Eingang (e1) eines Addierers (ad) gekoppelt sind, dessen zweiter Eingang (e2) mit dem Ausgang der letzten Verzögerungsstufe (vl) gekoppelt ist und dessen Ausgang am Dividend-Eingang (dd) eines Dividierers (dv) liegt, dessen Divisor-Eingang (ds) mit dem Ausgang der ersten Verzögerungsstufe (v1) gekoppelt ist und dessen Ausgangssignal (dm) entweder direkt oder nach Bildung der entsprechenden Arcussinus-Werte als demoduliertes Digitalsignal dient, gekennzeichnet durch folgende Merkmale:

— die Schaltungsanordnung ist für parallele Signalverarbeitung ausgelegt,

— die Kette von Verzögerungsstufen enthält, gebildet durch mindestens eine weitere gleichartige Stufe (vm), eine ungerade Anzahl von Verzögerungsstufen (v1, vm, vl), sodaß eine mittlere Stufe (vm) gebildet wird, deren Eingang am Minuend-Eingang (em) und deren Ausgang um Subtrahend-Eingang (es) eines Komparators (k) liegt,

— der jeweilige Eingang der ersten, mittleren bzw. letzten Verzögerungsstufe (v1, vm, vl) liegt am jeweiligen Ruhekontakteingang (er) eines ersten, zweiten bzw. dritten Bus-Umschalters (u1, u2, u3),

— der jeweilige Steuereingang der drei Bus-Umschalter (u1, u2, u3) ist mit dem Minuendgrößer-Subtrahend-Ausgang (ak) des Komparators (k) verbunden,

— der jeweilige Ausgang der ersten, mittleren bzw. letzten Verzögerungsstufe (v1, vm, vl) liegt am Arbeitskontakteingang (ea) des ersten, zweiten bzw. dritten Bus-Umschalters (u1, u2, u3), und

— der Ausgang des ersten (u1) der des dritten Bus-Umschalters (u3) liegen am ersten (e1) bzw. zweiten Eingang (e2) des Addierers (ad) und der Ausgang des zweiten Bus-Umschalters (u2) am Divisor-Eingang (ds) des Dividierers (dv).

2. Schaltungsanordnung nach Anspruch 1, dadurch gekennzeichnet, daß zwischen dem Arbeitskontakteingang (ea) des ersten Bus-Umschalters (u1) und dem Ruhekontakteingang (er) des zweiten Bus-Umschalters (u2) sowie zwischen dessen Arbeitskontakteingang (ea) und dem Ruhekontakteingang (er) des dritten Bus-Umschalters (u3) jeweils eine gerade Anzahl (n, r) von zusätzlichen Verzögerungsstufen (vn, vr) angeordnet ist.

3. Schaltungsanordnung nach Anspruch 2, dadurch gekennzeichnet, daß, insbesondere bei der digitalen FM-Demodulation von SECAM-Fernsehsignalen, jeweils sechs zusätzliche Verzögerungsstufen zwischen erster und mittlerer sowie dieser und letzter Verzögerungsstufe angeordnet sind.

**Revendications**

1. Circuit pour la démodulation de fréquence numérique d'échantillons temporellement équidistents (s0) dérivés d'un signal à modulation de fréquence analogique (FM) par échantillonnage à l'aide d'un signal d'échantillonnage (fa), qui sont fournis à l'entrée d'une chaîne de deux étages de retard arrangés en série (v1, vl), apporchacun un retard de la période du signal d'échantillonnage (fa), et sont couplés à la première entrée (e1) d'un additionneur (ad) dont la deuxième entrée (e2) est couplée à la sortie du dernier étage de retard (vl) et dont la sortie est connectée à l'entrée de dividende (dd) d'un diviseur (dv) dont l'entrée de diviseur (ds) est couplée à la sortie du premier étage de retard (v1) et dont le signal de sortie (dm) est utilisé, soit directement ou après formation de valeurs d'arc sinus correspondantes, comme signal numérique démodulé, caractérisé en ce que:

— le circuit est conçu pour un traitement en parallèle du signal,

— la chaîne d'étages de retard, grâce, à l'emploi d'au moins un étage additionnel similaire, contient un nombre impair d'étages de retard (v1, vm, vl), de sorte qu'il existe un étage médian (vm) dont l'entrée est connectée à l'entrée de terme principal (em) et dont la sortie est connectée à l'entrée de terme à soustraire (es) d'un comparateur (k),

— les entrées du premier étage, de l'étage médian et du dernier étage (v1, vm, v1) sont respectivement connectées aux entrées de contact de repos (er) d'un premier, d'un deuxième et d'un troisième commutateur de bus (u1, u2, u3),

— l'entrée de commande de chacun des trois commutateurs de bus (u1, u2, u3) est connectée à la sortie "terme principal plus grand que terme à soustraire" (ak) du comparateur (k),

— les sorties du premier étage, de l'étage médian et du dernier étage (v1, vm, vl) sont respectivement connectées aux entrées de contact de travail (ea) du premier, du deuxième et du troisième commutateur de bus (u1, u2, u3), et

— la sortie du premier (u1) et celle du troisième (u3) commutateur de bus sont respectivement connectées à la première (e1) et à la deuxième entrée (e2) de l'additionneur (ad), la sortie du deuxième commutateur de bus (u2) étant connectée à l'entrée de diviseur (ds) du diviseur (dv).

2. Circuit selon la revendication 1, caractérisé en ce qu'un nombre pair (n, r) d'étages de retard additionnels (vn, vr) sont arrangées respectivement entre les entrées de contact de travail (ea) du premier commutateur de bus (u1) et de contact de repos (er) du deuxième commutateur de bus (u2), de même qu'entre l'entrée du contact de travail (ea) de celui-ci et le contact de repos (er) du troisième commutateur de bus (u3).

3. Circuit selon la revendication 2, caractérisé en ce que, spécialement pour la démodulation de fréquence numérique de signaux de télévision SECAM, six étages de retard additionnels sont à chaque fois arrangés entre les étages de retard premier et médian, de même qu'entre les étages médian et dernier.

**Claims**

1. A circuit for the digital FM demodulation of temporarily equidistant samples (s0) derived from an analog frequency-modulated signal (FM) by way of sampling with the aid of a sampling signal (fa), which are fed to the input of a chain of two series-arranged delay stages each delaying by the period of the sampling signal (fa), and are coupled to the first input (e1) of an adder (ad) whose second input (e2) is coupled to the output of the last delay stage (vl) and whose output is connected to the dividend input (dd) of a divider (dv) whose divisor input (ds) is coupled to the output of the first delay stage (v1), and whose output signal (dm) is used either directly or after forming the corresponding arcus sinus values, as a demodulated digital signal, characterized by the following features:
— the circuit is designed for parallel signal processing,
— the chain of delay stages contains an odd number of delay stages (v1, vm, vl) at least one further stage (vm) of the same type and, thereby, forming a middle stage (vm), whose input is connected to the minuend input (em) and whose output is connected to the subtrahend input (es) of a comparator (k),
— the respective input of the first, middle and last delay stages (v1, vm, vl) is connected to the respective rest-contact input (er) of a first, second or third bus switch (u1, u2, u3), respectively,
— the respective control input of the three bus switches (u1, u2, u3) is connected to the minuend-greater-subtrahend-output (ak) of the comparator (k),
— the respective output of the first, middle, or last delay stages (v1, vm, vl) is connected to the operating-contact input (ea) of the first, second, or third bus switches (u1, u2, u3) respectively, and
— the output of the first (u1) and the output of the third bus switch (u3) are connected to the first (e1) or the second input (e2) of the adder (ad), and the output of the second bus switch (u2) is connected to the divisor input (ds) of the divider (dv).

2. A circuit as claimed in claim 1, characterized in that an even number (n, r) of additional delay stages (vn, vr) is arranged respectively between the operating, contact input (ea) of the first bus switch (u1) and the rest-contact input (er) of the second bus switch (u2) as well as between the operating-contact input (ea) thereof and the rest-contact input (er) of the third bus switch (u3).

3. A circuit as claimed in claim 2, characterized in that, especially for the digital FM demodulation of SECAM television signals, each time six additional delay stages are arranged between the first and the middle one, as well as between middle one and the last delay stage.

FIG.1

FIG. 2

$$n = r = 2i$$
$$i = 1, 2 \ldots$$

$$m = n + 1$$
$$m^I = n + 2$$
$$r^I = 2m$$
$$s = 2m + 1$$

0 109 966